# EUROPÄISCHE PATENTSCHRIFT

(11) **EP 3 296 144 B1**
(45) Veröffentlichungstag und Bekanntmachung des Hinweises auf die Patenterteilung: **29.04.2020**
(21) Anmeldenummer: 17182084.8
(22) Anmeldetag: 19.07.2017
(51) Int. Cl.: B60L 58/10, B60L 58/16, G01R 31/00, G01R 31/392, G01R 31/40

(54) **VERFAHREN ZUM BETREIBEN EINES BORDNETZES**
METHOD FOR OPERATING AN ON-BOARD NETWORK
PROCÉDÉ DE FONCTIONNEMENT D'UN CIRCUIT DE BORD

(30) Priorität: 14.09.2016 DE 102016217471
(43) Veröffentlichungstag der Anmeldung: 21.03.2018
(73) Patentinhaber: Robert Bosch GmbH, 70442 Stuttgart (DE)
(72) Erfinder: Muenzing, Patrick, 70734 Fellbach (DE); Koller, Oliver Dieter, 71384 Weinstadt (DE)

(56) Entgegenhaltungen:
- EP-A1- 2 738 908

## Beschreibung

Die Erfindung betrifft ein Verfahren zum Betreiben eines Bordnetzes in einem Kraftfahrzeug und eine Anordnung zur Durchführung des Verfahrens. Die Erfindung betrifft weiterhin ein Computerprogramm und ein maschinenlesbares Speichermedium.

### Stand der Technik

Unter einem Bordnetz ist die Gesamtheit aller elektrischen Komponenten in einem Fahrzeug zu verstehen. Insbesondere in Mehrspannungs-Bordnetzen werden Gleichspannungswandler eingesetzt. Ein Gleichspannungswandler ist eine elektrische Schaltung, die eine an deren Eingang angelegte Gleichspannung in eine Gleichspannung mit höherem, niedrigerem oder invertiertem Spannungsniveau wandelt. In Kraftfahrzeugen verwendete Bordnetze sind in vielen Fällen als Mehrspannungsnetze ausgebildet, die die elektrische Versorgung der Komponenten im Kraftfahrzeug sicherstellen.

Aufgrund der zunehmenden Elektrifizierung von Aggregaten sowie der Einführung von neuen Fahrfunktionen steigt die Anforderung an die Zuverlässigkeit der elektrischen Energieversorgung im Kraftfahrzeug.

Im Kraftfahrzeug steht der Fahrer bei einem zukünftigen automatisierten oder autonomen Fahrbetrieb nicht mehr als sensorische, regelungstechnische, mechanische und energetische Rückfallebene zur Verfügung. Das Fahrzeug übernimmt dessen Funktionen, wodurch aus Sicherheitssicht (ISO 26262) und nach der Bremsennorm (ECE R13) Bordnetze mir redundanten Kanälen unumgänglich sind.

Die Funktion des automatisierten bzw. autonomen Fahrens steht dem Nutzer nur dann zur Verfügung, wenn das Bordnetz in einwandfreiem Zustand ist. Um den Zustand des Systems zu ermitteln, werden die Bordnetz-Komponenten während des Betriebs überwacht und deren Schädigung ermittelt.

Die Druckschrift DE 10 2013 203 661 A1 beschreibt ein Verfahren zum Betreiben eines elektrifizierten Kraftfahrzeugs und Mittel zu dessen Implementierung. Das Kraftfahrzeug weist ein Bordnetz mit wenigstens einem Halbleiterschalter auf, der während des Betriebs des Kraftfahrzeugs aufgrund wenigstens eines belastungsbeeinflussenden Faktors mit Belastungsereignissen belastet wird. Zudem ist für den Halbleiterschalter eine Lebensdauer-Belastungsbeziehung vorgesehen, die für eine Nennbelastung eine Nennlebensdauer angibt. Mit dieser kann für wenigstens einen Zeitpunkt innerhalb der Nennbelastungsdauer ein dem wenigstens einen Zeitpunkt entsprechender Nennbelastungsanteil ermittelt weden. Das Verfahren ermöglicht es, auf stark streuende Belastungen und die damit verbundenen, ebenfalls streuenden Ausfallzeitpunkte des Halbleiterschalters zu reagieren.

Es ist bekannt, eine einmalige Auslegung der Betriebsstrategie in einem bestimmten Schädigungsverhältnis einer Batterie zum Gleichspannungswandler durchzuführen. Diese Auslegung basiert auf Fahrzyklen, welche die Fahrzeugnutzung abschätzen und somit eine gewisse Ungenauigkeit aufweisen. Bei abweichender Fahrzeugnutzung werden die Batterie und der Gleichspannungswandler nicht lebensdaueroptimal beansprucht.

Als Resultat der suboptimalen Nutzung wird das automatisierte bzw. autonome Fahren nicht freigeschaltet. Häufige Werkstattbesuche werden nötig, was den Kunden unnötig finanziell und zeitlich belastet und so zu Unzufriedenheit mit dem Fahrzeug führt. Die ungenutzte Lebensdauer der Komponenten ist gleichzusetzen mit verschwendeten Kosten, da die Komponente nicht bis zum vorgesehenen Grad genutzt wurde.

Einschub für die Beschreibung Einleitung (anzufügen an Seite 2, Zeile 32 der ursprünglichen Beschreibung)

Die Druckschrift EP 2 738 908 A1 beschreibt ein Verfahren zum Betreiben eines Batteriesystems in einem Kraftfahrzeug, wobei in dem Batteriesystem mehrere Batteriegruppen vorgesehen sind. Dabei werden Informationen von jeder Batteriegruppe einer Steuerung zugeführt.

### Offenbarung der Erfindung

Vor diesem Hintergrund werden ein Verfahren gemäß Anspruch 1 und eine Anordnung gemäß Anspruch 8 vorgestellt. Es werden weiterhin ein Computerprogramm gemäß Anspruch 9 und ein maschinenlesbares Speichermedium mit den Merkmalen des Anspruchs 10 vorgestellt. Ausgestaltungen ergeben sich aus den abhängigen Ansprüchen und der Beschreibung.

Das vorgestellte Verfahren ermöglicht es, durch eine schädigungsabhängige Wandler-Betriebsstrategie mindestens einen Energiespeicher, bspw. einer Batterie, und mindestens einen Gleichspannungswandler lebensdaueroptimal zu betreiben. Dies ist in Ausgestaltung durch eine reine Softwareimplementierung realisierbar und dadurch preisgünstig zu verwirklichen.

Das Verfahren kann grundsätzlich auch bei mehreren Gleichspannungswandlern und mehreren Energiespeichern, auch bei Energiespeicher unterschiedlicher Art, durchgeführt werden.

Durch die Implementierung der Erfindung ist eine kostenoptimale Nutzung des Energiespeichers und des Gleichspannungswandlers gewährleistet. Werkstattaufenthalte des Kunden werden verringert, wodurch die Kundenzufriedenheit gesteigert wird.

Die vorgestellte Anordnung ist zur Durchführung des vorgestellten Verfahrens eingerichtet und kann bspw. in einem Steuergerät des Kraftfahrzeugs bspw. als Software bzw. als Computerprogramm implementiert sein. Dieses Computerprogramm wiederum kann auf einem maschinenlesbaren Speichermedium abgelegt sein. Zudem wird hierin ein Bordnetz vorgestellt, dass derart eingerichtet ist, dass dieses zu Durchführung des beschriebenen Verfahrens geeignet ist.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Kurze Beschreibung der Zeichnungen
Figur 1 zeigt eine Ausführung eines Bordnetzes zur Durchführung des Verfahrens.
Figur 2 zeigt in sechs Graphen die Komponentenlebensdauer in Abhängigkeit der Gleichspannungswandler-Betriebsstrategie.
Figur 3 zeigt in zwei Graphen das Prinzip der lebensdaueroptimierten Auslegung einer Batterie und eines Gleichspannungswandlers.

Die Erfindung ist anhand von Ausführungsformen in den Zeichnungen schematisch dargestellt und wird nachfolgend unter Bezugnahme auf die Zeichnungen ausführlich beschrieben.

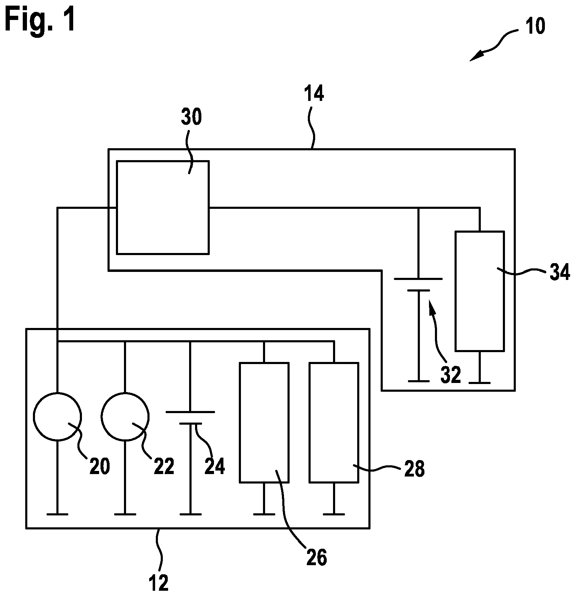

Eine Ausführung eines redundanten Fahrzeug-Bordnetzes ist in Figur 1 dargestellt und insgesamt mit der Bezugsziffer 10 bezeichnet. Dieses Bordnetz 10 umfasst ein Basisbordnetz 12, das auch als erster Kanal bezeichnet wird und mit 12 Volt betrieben ist, sowie einen angekoppelten zweiten Kanal 14, der ebenfalls mit 12 Volt betrieben ist.

In dem Basisbordnetz 12 sind ein Starter 20, ein Generator 22, eine erste Batterie B1 24, ein nicht sicherheitsrelevanter Verbraucher R3 26 und ein sicherheitskritischer Verbraucher R1a 28 vorgesehen. Der Verbraucher R3 26 steht stellvertretend für alle nicht sicherheitsrelevanten Verbraucher im Basisbordnetz 12. Der Verbraucher R1a 28 steht stellvertretend für die sicherheitsrelevanten Verbraucher im Basisbordnetz 12, die den ersten Teil der redundanten Funktionserfüllung darstellen. In dem zweiten Kanal 14 sind ein Gleichspannungswandler 30, eine zweite Batterie B2 32 und ein sicherheitskritischer Verbraucher R1b 34 vorgesehen. Der Verbraucher R1b 34 steht stellvertretend für die sicherheitsrelevanten Verbraucher im zweiten Kanal 14, die den zweiten Teil der redundanten Funktionserfüllung darstellen. Die Verbraucher R1a 28 und R1b 34, die redundant zueinander sind, stehen stellvertretend für die Verbraucher, die zur redundanten Funktionserfüllung der sicherheitsrelevanten Funktionen, wie bspw. Lenken, Bremsen usw., vorgesehen sind.

Die für das vorgestellte Verfahren wichtige Komponenten sind der Gleichspannungswandler 30, der als Koppelelement zwischen den beiden Kanälen 12 und 14 dient, und die Batterie B2 32, die einen Energiespeicher darstellt und bspw. als Blei-Batterie ausgebildet ist. Zu beachten sind ebenso Spannungsschwankungen im zweiten Kanal 14, die bspw. durch Verbraucherzu- und -abschaltungen verursacht werden. Weitere möglichen Bordnetz-Spannungslevels sind neben den gezeigten 12 V/12 V die 12 V/48 V- und 12 V/HV-Varianten.

Wie bereits ausgeführt wurde, steht die Funktion des automatisierten bzw. autonomen Fahrens dem Nutzer nur dann zur Verfügung, wenn das Bordnetz in einwandfreiem Zustand ist. Um dies sicherzustellen, werden die Bordnetz-Komponenten während des Betriebs überwacht und deren Schädigung ermittelt.

Zur Schädigungsermittlung der Blei-Batterie B2 32 können die im Betrieb erfahrenen Beschädigungs-/Belastungs-Zyklen gezählt und unter Berücksichtigung weiterer Einflussparameter aufsummiert werden. Durch den Vergleich der Schädigung mit der Belastbarkeit der Batterie und/oder einem vorgegebenen Grenzwert, kann die verbleibende Lebensdauer der Batterie B2 32 prognostiziert werden.

Bei der Berechnung der Batterieschädigung werden folgende Kenngrößen berücksichtigt:
- Amplitude bzw. Gesamthöhe der bisher erfahrenen SOC-Hübe (SOC: state of Charge) der Batterie
- Mitten der SOC-Hübe
- Beginn und Dauer der Hübe
- Batterie-Temperatur während den Hüben

Weitere mögliche Einflussparameter sind:
- Lade- und Entladeströme der Batterie
- kalendarische Alterung durch Ruhezeiten

Bei dem Gleichspannungswandler 30 können anhand elektrischer Ein- und Ausgangsgrößen, bspw. anhand der Ein- und Ausgangsströme und -spannungen, Temperaturhübe im Gleichspannungswandler ermittelt werden. Diese Temperaturhübe können in eine Schädigung des Wandlers umgerechnet werden. Durch Vergleich mit der Belastbarkeit der Batterie und/oder einem vorgegebenen Grenzwert kann die verbleibende Lebensdauer des Gleichspannungswandlers 30 berechnet werden. Grundsätzlich können die Temperaturhübe auch über direkt über Temperaturmessungen, bspw. mittels geeigneter Sensoren, ermittelt werden.

Es wurde erkannt, dass zwischen der Schädigung der Batterie B2 32 und der Schädigung des Gleichspannungswandlers 30 ein Zusammenhang besteht. Sowohl die Zyklen der Batterie B2 32 als auch die Temperaturhübe im Gleichspannungswandler 30 werden durch die Kompensation von dynamischen Spannungsschwankungen hervorgerufen und die Komponenten dadurch geschädigt. Abhängig von der Betriebsstrategie des Gleichspannungswandlers 30 kann die Schädigung auf die Batterie B2 32 und den Gleichspannungswandler 30 verteilt werden.

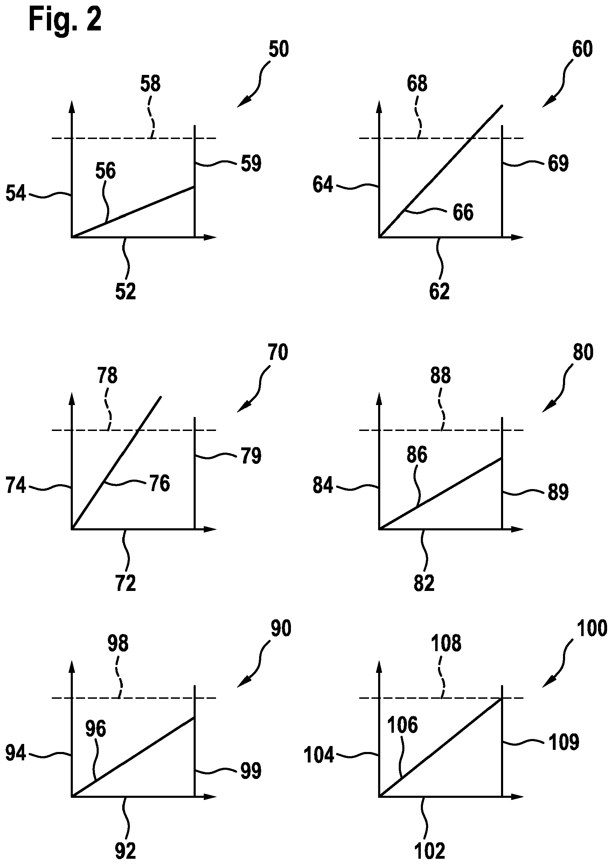

In Figur 2 sind drei Fälle, die hierbei auftreten können, dargestellt, die ebenfalls in möglichen Ausführungen des vorgestellten Verfahrens verwirklicht werden können:

### 1. Batterie-Nullstrom-Regelung

In einem ersten Graphen 50, an dessen Abszisse 52 die Lebensdauer der Batterie und an dessen Ordinate 54 die Schädigung aufgetragen ist, ist der Verlauf 56 der Schädigung der Batterie verdeutlicht. Weiterhin verdeutlicht eine gestrichelte Linie 58 das Ende der Lebensdauer der Batterie. Eine Linie 59 zeigt deren spezifizierte Lebensdauer.

In einem zweiten Graphen 60, an dessen Abszisse 62 die Lebensdauer des Gleichspannungswandlers und an dessen Ordinate 64 die Schädigung aufgetragen ist, ist der Verlauf 66 der Schädigung des Gleichspannungswandlers verdeutlicht. Weiterhin verdeutlicht eine gestrichelte Linie 68 das Ende der Lebensdauer des Gleichspannungswandlers. Eine Linie 69 zeigt dessen spezifizierte Lebensdauer.

Die Zyklisierung der Blei-Batterie B2 wird bspw. durch eine Batterie-Nullstrom-Regelung minimal gehalten. Dadurch erfährt die Batterie eine geringe Schädigung und übertrifft die spezifizierte Lebensdauer.

Der Gleichspannungswandler kompensiert die dynamischen Spannungsschwankungen, wodurch es zu maximalen Temperaturhüben im Gleichspannungswandler kommt. Die Temperaturhübe führen zur maximalen Schädigung des Wandlers. Die spezifizierte Lebensdauer wird unterschritten, der Wandler fällt zu früh aus.

### 2. Träger Wandler

In einem dritten Graphen 70, an dessen Abszisse 72 die Lebensdauer der Batterie und an dessen Ordinate 74 die Schädigung aufgetragen ist, ist der Verlauf 76 der Schädigung der Batterie verdeutlicht. Weiterhin verdeutlicht eine gestrichelte Linie 78 das Ende der Lebensdauer der Batterie. Eine Linie 79 zeigt deren spezifizierte Lebensdauer.

In einem vierten Graphen 80, an dessen Abszisse 82 die Lebensdauer des Gleichspannungswandlers und an dessen Ordinate 84 die Schädigung aufgetragen ist, ist der Verlauf 86 der Schädigung des Gleichspannungswandlers verdeutlicht. Weiterhin verdeutlicht eine gestrichelte Linie 88 das Ende der Lebensdauer des Gleichspannungswandlers. Eine Linie 89 zeigt dessen spezifizierte Lebensdauer.

Es wurde erkannt, dass die Temperaturhübe im Gleichspannungswandler durch einen trägen Wandler minimal gehalten werden. Dieser Gleichspannungswandler reagiert nicht sofort auf jede Spannungsspitze. Dadurch ist die Schädigung des Gleichspannungswandlers minimal. Dieser übertrifft somit seine spezifizierte Lebensdauer.

Die Batterie B2 nimmt die dynamischen Spannungsschwankungen auf und wird dementsprechend maximal zyklisiert. Die Zyklisierung führt zu maximaler Schädigung der Batterie B2. Die Batterie B2 unterschreitet die spezifizierte Lebensdauer und fällt zu früh aus.

### 3. Statisches Schädigungsverhältnis

In einem fünften Graphen 90, an dessen Abszisse 92 die Lebensdauer der Batterie und an dessen Ordinate 94 die Schädigung aufgetragen ist, ist der Verlauf 96 der Schädigung der Batterie verdeutlicht. Weiterhin verdeutlicht eine gestrichelte Linie 98 das Ende der Lebensdauer der Batterie. Eine Linie 99 zeigt deren spezifizierte Lebensdauer.

In einem sechsten Graphen 100, an dessen Abszisse 102 die Lebensdauer des Gleichspannungswandlers und an dessen Ordinate 104 die Schädigung aufgetragen ist, ist der Verlauf 106 der Schädigung des Gleichspannungswandlers verdeutlicht. Weiterhin verdeutlicht eine gestrichelte Linie 108 das Ende der Lebensdauer des Gleichspannungswandlers. Eine Linie 109 zeigt dessen spezifizierte Lebensdauer.

Die Wahl der Betriebsstrategie liegt zwischen der zuvor dargelegten 1. und 2. Bedienstrategie. Es zeigt sich, dass die Schädigung sich durch geeignete Parametrierung so einstellen lässt, dass ein gewünschtes, statisches Schädigungsverhältnisses zwischen der Schädigung des Gleichspannungswandlers und der Schädigung der Batterie B2 erreicht wird.

Es kann eine einmalige Auslegung der Betriebsstrategie in einem bestimmten Schädigungsverhältnis der Batterie B2 zum Gleichspannungswandler stattfinden. Diese Auslegung basiert auf Fahrzyklen, welche die Fahrzeugnutzung abschätzen und somit eine gewisse Ungenauigkeit aufweisen. Bei abweichender Fahrzeugnutzung werden die Batterie B2 und der Gleichspannungswandler nicht lebensdaueroptimal beansprucht.

Als Resultat der suboptimalen Nutzung wird das automatisierte bzw. autonome Fahren, wie dies eingangs beschrieben ist, nicht freigeschaltet. Häufige Werkstattbesuche werden nötig, was den Kunden unnötig finanziell und zeitliche belastet und so zu Unzufriedenheit mit dem Fahrzeug führt. Insbesondere führt die ungenutzte Lebensdauer der Komponenten zu erhöhten Kosten, da die Komponente nicht bis zum vorgesehenen Grad genutzt wurde.

Es wird nunmehr vorgeschlagen, durch eine schädigungsabhängige Wandler-Betriebsstrategie die Batterie B2 und den Gleichspannungswandler lebensdaueroptimal zu betreiben. Auf diese Weise ist eine kostenoptimale Nutzung der Batterie B2 und des Gleichspannungswandlers gewährleistet.

Die Anpassung der Wandler-Betriebsstrategie setzt die Ermittlung der Schädigung der Batterie B2 und des Gleichspannungswandlers im Fahrzeugbetrieb voraus. Dies ist für den automatisierten bzw. autonomen Betrieb erforderlich, da die Funktion nur im einwandfreien Zustand des Fahrzeuges freigeschaltet wird. Es wurde erkannt, dass die Feststellung des einwandfreien Zustandes nur über die Ermittlung der schädigungsrelevanten Parameter möglich ist.

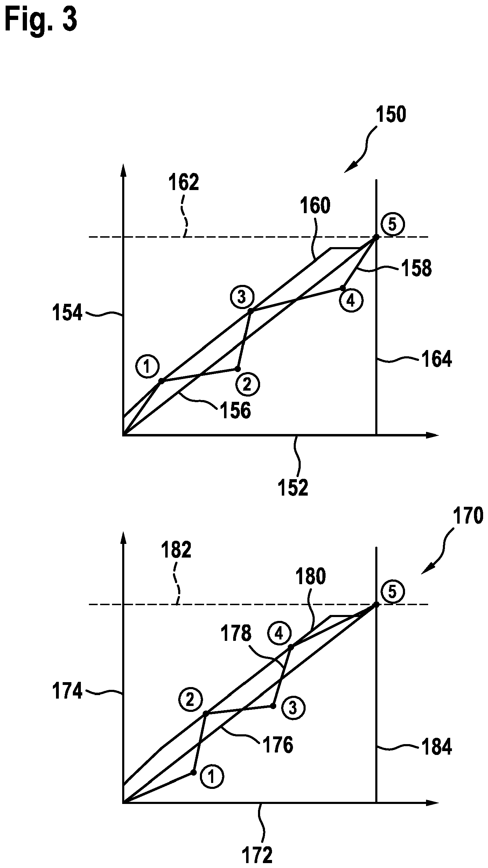

Ein mögliches Prinzip zur Realisierung der Wandler-Betriebsstrategie auf Basis der Schädigung der Batterie B2 und des Wandlers ist in Figur 3 dargestellt.

Figur 3 zeigt in einem ersten Graphen 150, an dessen Abszisse 152 die Lebensdauer der Batterie und an dessen Ordinate 154 die Schädigung aufgetragen ist, den Sollverlauf 156 und den Istverlauf 158 der Schädigung der Batterie sowie eine Korrekturgrenze 160. Weiterhin verdeutlicht eine gestrichelte Linie 162 das Ende der Lebensdauer der Batterie. Eine Linie 164 zeigt deren spezifizierte Lebensdauer.

In einem zweiten Graphen 170, an dessen Abszisse 172 die Lebensdauer des Gleichspannungswandlers und an dessen Ordinate 174 die Schädigung aufgetragen ist, sind der Sollverlauf 176 und der Istverlauf 178 der Schädigung des Gleichspannungswandlers sowie eine Korrekturgrenze 180 eingetragen. Weiterhin verdeutlicht eine gestrichelte Linie 182 das Ende der Lebensdauer des Gleichspannungswandlers. Eine Linie 184 zeigt dessen spezifizierte Lebensdauer.

Es werden folglich für die Batterie B2 und für den Gleichspannungswandler anhand der spezifizierten Lebensdauer Soll-Schädigungsverläufe vorgegeben. Oberhalb der Sollschädigungsverläufe werden bei dieser Ausführung Grenzverläufe bzw. Korrekturgrenzen definiert, die zu keinem Zeitpunkt überschritten werden dürfen.

Es wird somit das Bordnetz derart betrieben, dass die ermittelten bzw. berechneten oder prognostizierten Schädigungen die zugeordneten Soll-Schädigungsverläufe berücksichtigen.

In Figur 3 erreicht die Schädigung der Batterie B2 im Punkt 1 die Korrekturgrenze 160. Daraufhin wird die Wandler-Betriebsstrategie so angepasst, dass die Batterie weniger geschädigt wird, wodurch die Schädigung im Gleichspannungswandler stärker zunimmt. Bei Punkt 2 erreicht die Schädigung des Gleichspannungswandlers die Korrekturgrenze 160, wodurch die Schädigung des Gleichspannungswandlers verringert wird und die Batterie wieder stärker geschädigt wird. Auf diese Weise lässt sich die Lebensdauer beider Komponenten optimal bis zu Punkt 5 ausnutzen.

Weiterhin denkbar ist, dass sich die Betriebsstrategie insoweit an das Fahrprofil anpasst, dass eine optimale Annäherung an die Schädigungssollverläufe möglich ist. Ebenso sind andere Geometrien für die Verläufe denkbar.

Bei Durchführung des beschriebenen Verfahrens kann sich bei dauerhaft hochdynamischer Spannungsbelastung des Bordnetzes ein Wechsel der Wandler-Betriebsstrategie durch abweichend starke Schädigung der Batterie bzw. des Gleichspannungswandlers zeigen.

Bei konstanten hochdynamischen Spannungsschwankungen im zweiten Kanal kann für die Batterie der Amperestundendurchsatz zeitabhängig ermittelt werden. Gleichzeitig können zeitabhängige Temperaturmessungen am Gleichspannungswandler durchgeführt werden. In diesem Fall verhält sich der Amperestundendurchsatz der Batterie antizyklisch zum Temperaturverhalten des Gleichspannungswandlers.

Das vorgestellte Verfahren und die beschriebene Anordnung können grundsätzlich in mehrkanaligen Bordnetzen mit gleichen oder abweichenden Spannungsniveaus, wie bspw. in einem zweikanaligen 12 V/48 V, 12 V/12 V, 12 V/HV, 48 V/48 V, HV/HV, eingesetzt werden.

Ein Einsatz ist bei allen Systemen möglich, die einen Gleichspannungswandler umfassen, der Energie in einen batteriebestückten Kanal transportiert und die lebensdaueroptimal ausgelegt werden sollen.

## Patentansprüche

1. Verfahren zum Betreiben eines Bordnetzes (10) in einem Kraftfahrzeug, wobei das Bordnetz (10) einen Gleichspannungswandler (30) und einen Energiespeicher (32) aufweist, wobei im Betrieb des Bordnetzes (10) eine Schädigung des Gleichspannungswandlers (30) und eine Schädigung des Energiespeichers (32) ermittelt wird, wobei sowohl für den Gleichspannungswandler (30) als auch für den Energiespeicher (32) jeweils ein Soll-Schädigungsverlauf (156, 176) vorgegeben wird und das Bordnetz (10) durch Anpassung der Betriebsstrategie des Gleichspannungswandlers (30) derart betrieben wird, dass die ermittelten Schädigungen jeweils den zugeordneten Soll-Schädigungsverlauf (156, 176) berücksichtigen.

2. Verfahren nach Anspruch 1, bei dem zu den Soll-Schädigungsverläufen (156, 176) jeweils eine Korrekturgrenze (160, 180) definiert wird und das Bordnetz (10) derart betrieben wird, dass die Korrekturgrenzen (160, 180) durch die ermittelten Schädigungen nicht überschritten werden.

3. Verfahren nach Anspruch 1 oder 2, bei dem zur Ermittlung der Schädigung des Gleichspannungswandlers (30) Temperaturhübe in dem Gleichspannungswandler (30) ermittelt werden, die in eine Schädigung umgerechnet werden.

4. Verfahren nach Anspruch 3, bei dem anhand erfasster elektrischer Ein- und Ausgangsgrößen des Gleichspannungswandlers (30) die Temperaturhübe ermittelt werden.

5. Verfahren nach einem der Ansprüche 1 bis 4, bei dem zur Ermittlung der Schädigung des Energiespeichers (32) erfahrene Zyklen aufsummiert werden.

6. Verfahren nach Anspruch 5, bei dem durch Vergleich der ermittelten Schädigung mit der Belastbarkeit des Energiespeichers (32) und/oder einem vorgegebenen Grenzwert eine verbleibende Lebensdauer des Energiespeichers (32) prognostiziert wird.

7. Verfahren nach einem der Ansprüche 1 bis 6, bei dem in Abhängigkeit der ermittelten Schädigungen ein automatisierter Betrieb des Kraftfahrzeugs freigeschaltet wird.

8. Anordnung, die dazu eingerichtet ist, ein Verfahren nach einem der Ansprüche 1 bis 7 auszuführen.

9. Computerprogramm mit Programmcodemitteln, das eingerichtet ist, ein Verfahren nach einem der Ansprüche 1 bis 7 auszuführen, wenn das Computerprogramm auf einer Recheneinheit ausgeführt wird.

10. Maschinenlesbares Speichermedium, auf dem das Computerprogramm nach Anspruch 9 gespeichert ist.

## Claims

1. Method for operating a vehicle electrical system (10) in a motor vehicle, wherein the vehicle electrical system (10) has a DC-DC converter (30) and an energy store (32), wherein a damage to the DC-DC converter (30) and a damage to the energy store (32) are ascertained during operation of the vehicle electrical system (10), wherein a respective specified damage characteristic (156, 176) is prescribed both for the DC-DC converter (30) and for the energy store (32), and the vehicle electrical system (10) is operated, by adapting the operating strategy of the DC-DC converter (30), such that the ascertained damages each make allowance for the associated specified damage characteristic (156, 176) .

2. Method according to Claim 1, in which a respective correction limit (160, 180) is defined for the specified damage characteristics (156, 176), and the vehicle electrical system (10) is operated such that the correction limits (160, 180) are not exceeded by the ascertained damages.

3. Method according to Claim 1 or 2, in which the damage to the DC-DC converter (30) is ascertained by ascertaining temperature swings in the DC-DC converter (30), which are converted into a damage.

4. Method according to Claim 3, in which the temperature swings are ascertained on the basis of captured electrical input and output variables of the DC-DC converter (30).

5. Method according to one of Claims 1 to 4, in which the damage to the energy store (32) is ascertained by summing undergone cycles.

6. Method according to Claim 5, in which a remaining life of the energy store (32) is forecast by comparing the ascertained damage with the loading capacity of the energy store (32) and/or with a prescribed limit value.

7. Method according to one of Claims 1 to 6, in which automated operation of the motor vehicle is enabled on the basis of the ascertained damages.

8. Arrangement configured to carry out a method according to one of Claims 1 to 7.

9. Computer program having program code means that is configured to carry out a method according to one of Claims 1 to 7 when the computer program is executed on a computing unit.

10. Machine-readable storage medium on which the computer program according to Claim 9 is stored.

## Revendications

1. Procédé pour faire fonctionner un réseau de bord (10) dans un véhicule automobile, le réseau de bord (10) possédant un convertisseur de tension continue (30) et un accumulateur d'énergie (32), une dégradation du convertisseur de tension continue (30) et une dégradation de l'accumulateur d'énergie (32) lors du fonctionnement du réseau de bord (10) étant déterminées, une courbe de dégradation de consigne (156, 176) étant respectivement prédéfinie à la fois pour le convertisseur de tension continue (30) et pour l'accumulateur d'énergie (32) et le fonctionnement du réseau de bord (10) s'effectuant en adaptant la stratégie de fonctionnement du convertisseur de tension continue (30) de telle sorte que les dégradations déterminées tiennent respectivement compte de la courbe de dégradation de consigne (156, 176) associée.

2. Procédé selon la revendication 1, avec lequel une limite de correction (160, 180) est respectivement définie pour les courbes de dégradation de consigne (156, 176) et le fonctionnement du réseau de bord (10) s'effectue de telle sorte que les limites de correction (160, 180) ne sont pas dépassées par les dégradations déterminées.

3. Procédé selon la revendication 1 ou 2, avec lequel la dégradation du convertisseur de tension continue (30) est déterminée en déterminant des excursions de température dans le convertisseur de tension continue (30), lesquelles sont converties en une dégradation.

4. Procédé selon la revendication 3, avec lequel les excursions de température sont déterminées à l'aide des grandeurs électriques d'entrée et de sortie du convertisseur de tension continue (30).

5. Procédé selon l'une des revendications 1 à 4, avec lequel les cycles traversés sont additionnés en vue de déterminer la dégradation de l'accumulateur d'énergie (32) .

6. Procédé selon la revendication 5, avec lequel une durée de vie restante de l'accumulateur d'énergie (32) est pronostiquée par une comparaison de la dégradation déterminée avec la capacité de charge de l'accumulateur d'énergie (32) et/ou une valeur limite prédéfinie.

7. Procédé selon l'une des revendications 1 à 6, avec lequel un fonctionnement automatisé du véhicule automobile est validé en fonction des dégradations déterminées.

8. Arrangement qui est conçu pour mettre en œuvre un procédé selon l'une des revendications 1 à 7.

9. Programme informatique, comprenant des moyens de code de programme, qui est conçu pour mettre en œuvre un procédé selon l'une des revendications 1 à 7 lorsque le programme informatique est exécuté sur une unité de calcul.

10. Support d'enregistrement lisible par machine sur lequel est enregistré le programme informatique selon la revendication 9.
